# EUROPEAN PATENT APPLICATION

(11) **EP 4 344 365 A1**
(43) Date of publication of application: **27.03.2024**
(21) Application number: 23198436.0
(22) Date of filing: 20.09.2023
(51) Int. Cl.: H05K 3/20, H05K 3/28, H05K 3/00, H05K 3/46

(54) **THIN PRINTED CIRCUIT BOARD WITH ACCESSIBILITY IN BOTH SIDES AND RELATED PRODUCTION METHOD**

(30) Priority: 22.09.2022 IT 202200019464
(71) Applicant: Cisel S.r.l. - Circuiti Stampati Per Applicazioni Elettroniche, 60022 Castelfidardo (AN) (IT)
(72) Inventor: FIORETTI, Emanuela, 00185 ROMA (IT)
(74) Representative: Cutropia, Gianluigi

(57) **Abstract**

A printed circuit board (100), of the double-sided type, comprises a single sheet of conductive material (3), etched with conductive tracks (32) and sandwiched between a first sheet (2) of insulating material and a second sheet (4) of insulating material; the first sheet (2) of insulating material and the second sheet (4) of insulating material having openings (25; 45) to allow access to the sheet (3) of conductive material at areas which in the printed circuit board (100) must be uncovered areas intended for soldering electronic components or connections to external circuits on the upper face (F1) and on the lower face (F2) of the printed circuit board (100); the conductive material sheet (3) and the first and second material sheets (2, 4) are thin flexible sheets, so as to obtain a thin flexible printed circuit board.

## Description

The present invention refers to the field of double-sided printed circuit boards, ie a printed circuit board having two faces on which electronic components can be soldered or connections to external circuits can be made. The present invention relates in particular to a printed circuit board having a single conductive layer accessible from both faces of the printed circuit board, and to a method of manufacturing such a printed circuit board.

In printed circuit boards there is the need to connect at least one electronic component to at least one external connection. Generally it is necessary to connect hundreds or even thousands of components to each other and to external connections, according to a predetermined wiring diagram.

The prior art, in this sector, typically provides for the manufacture of a multilayer printed circuit board, consisting of an alternation of insulating and conductive layers, pressed together, in which the connections between the various conductive layers are made by through holes or blind holes, internally metallized by means of a process known to those skilled in the art. This technique has the advantage of allowing the interconnection of a large number of electronic components with a network, even very complex, of connections constituting a functional circuit or a module of an equipment.

A second case is that of circuits intended to conduct relatively high current flows, where the need to have access to the conductive layers from both sides of the printed circuit board is usually solved with the use of at least two copper conductive layers placed on the external sides, connected by a large number of metallized interconnection holes.

The current technique also involves a number of disadvantages, among which the complexity of the procedure which involves dozens of stages of lamination, etching, pressing, drilling, metallization, screen printing, contouring, etc. Furthermore, the circuit obtained is rigid and the internal metallization of the interconnection holes are fragile and difficult to control. According to the prior art, the circuit is made starting from a laminate of epoxy material filled with glass fiber on which two layers of copper are laminated on the opposite sides; after etching to create conductive tracks on these copper layers, further insulating and conductive layers can be added, ending with two external conductive layers on which the electronic components are mounted and the connections made.

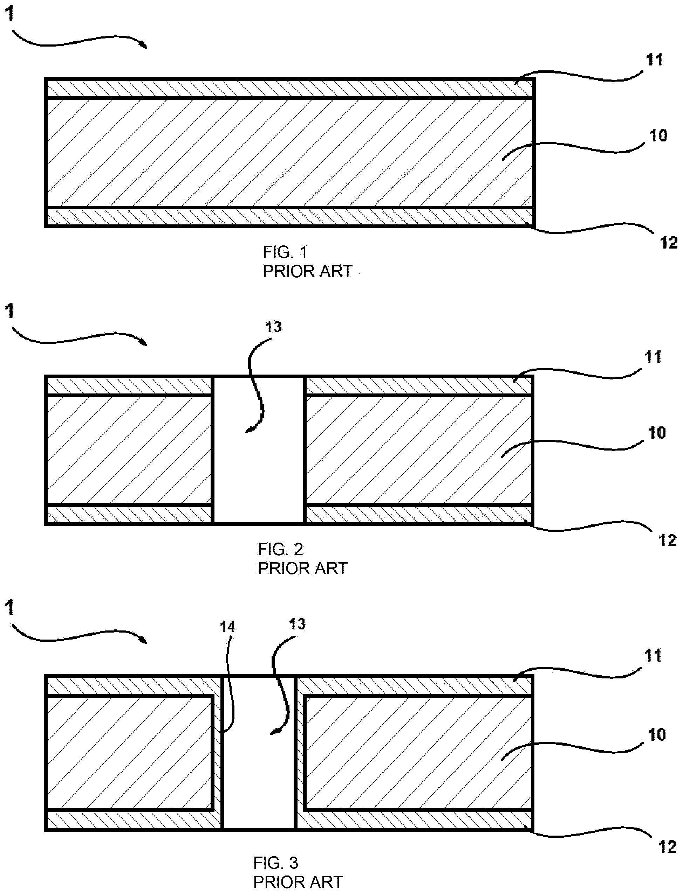

With reference to Fig. 1, the printed circuit board (1) is made starting from a sheet (10) of insulating material as a support on which two sheets (11, 12) of conductive material are laminated.

The sheets (11, 12) of conductive material typically are of annealed copper, but in some cases may be of other kind of metal.

With reference to Fig. 2, at least one through hole (13) is made in the printed circuit (1).

With reference to Fig. 3, the two sheets (11, 12) of conductive material are electrically connected by metallization (14) of the internal walls of the through hole (13). Subsequently, the printed circuit (1) is subjected to silk-screen or photographic masking processes and conductive tracks are etched on the two sheets (11, 12) of conductive material, according to a predetermined wiring diagram.

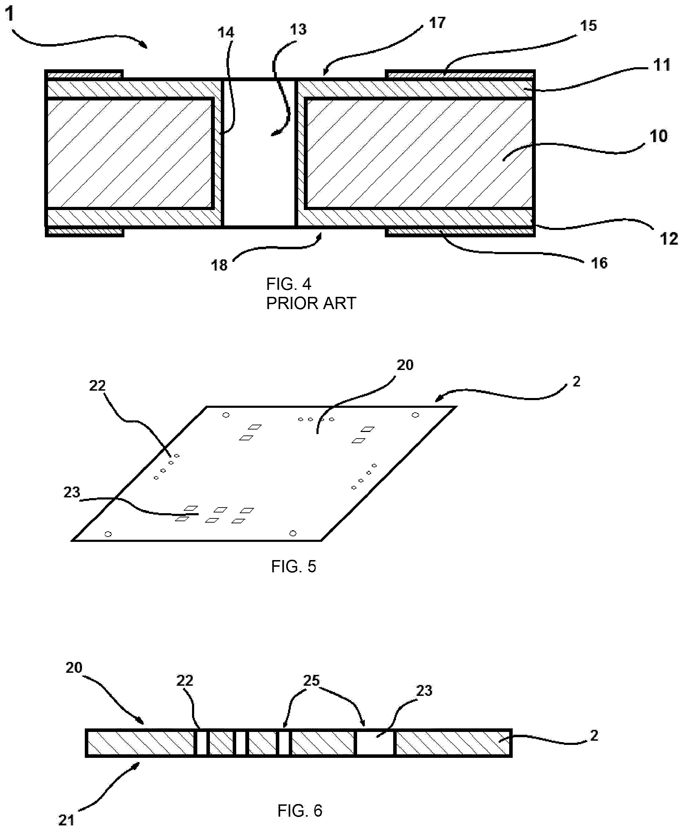

With reference to Fig. 4, finally it is shown that, after the etching of the conductive tracks on the two sheets (11, 12) of conductive material, two other layers (15, 16) of insulating material can optionally be deposited with protective functions, leaving areas (17, 18) of conductive material uncovered, on which soldering of electronic components or connections to other circuits can be made.

This known process involves a sequence of chemical and galvanic processing stages with a considerable ecological impact and therefore the need for purification and recovery or disposal of the residues, which costs significantly affect the entire process. The connections of the electronic components and the connections to the outside are typically made by soldering with a tin-based alloy, with various manual or automatic methods, typically by wave soldering, by selective wave, or by melting a solder paste deposited by screen printing, or by gluing with conductive resins.

In the plurality of practical applications an high complexity of a printed circuit boards is not always required. There are some applications in which a printed circuit board has to house few components, despite having, for geometric reasons, a relatively large size. In this case one is forced to use a relatively expensive technology on a large size product, without the real need for high complexity. Examples of these cases can be printed circuit boards used to connect terminations of photovoltaic solar cells, or printed circuit boards placed behind equipment dashboards. In these cases, the printed circuit board has geometric dimensions defined by mechanical or aesthetic requirements, but has to house few components and connections per unit area. Often in this type of application, in order to make relatively few connections over a large surface area, most of the copper surface is eliminated during the etching phase, thus wasting a very expensive material.

US3072734A (Fox et al., 1963) and US2613252 (Heibel, 1952) disclose a double-sided printed circuit board having a sheet of conductor material sandwiched between two sheets of insulating material. The sheet of conductive material is a thick, rigid sheet in which holes and tracks are made by punching the conductive sheet. Even the insulating sheets are rigid and holes are made in them by mechanical punching.

As a result, is obtained a rigid, i.e. non-flexible, printed circuit board having an high thickness.

Furthermore, the production method of this circuit, based on the mechanical punching of the conductive sheet and the insulating sheets, can be industrialized only at high costs and for large mass productions, and is not suitable for miniaturized circuits or with a complex design of conductive tracks.

AT273542B (Stillit, 1963) and NL7601969 (Verlag, 1975) disclose printed circuits boards for games. However, these circuits are very simple and are made by shearing or punching, so as to simply make communication between two pads of the circuit to define in the game whether the answer is correct or incorrect. Surely these printed circuits are not intended for the creation of complex electronic circuits, nor for the assembly of electronic components.

Object of the present invention is to eliminate the drawbacks of the prior art by providing a double-sided printed circuit board which saves the conductive metal material and which can be industrialized for productions of any quantity, even for samples and small productions, and suitable for creating complex designs, to the miniaturization of the printed circuit board and the assembly of electronic components.

Another object is to provide such a method for manufacturing a printed circuit board which is simple, rapid, efficient and reliable.

These objects are achieved according to the invention with the characteristics of the independent claims.

Further advantageous embodiments of the invention appear from the dependent claims.

The proposed embodiment substantially reverses the assembly and processing sequence of the printed circuit board, placing the etched conductive layer in the middle of the printed circuit board and laminating the insulating layers on both faces of the conductive layer.

The manufacturing process includes the following stages:
- preparation of a first sheet of insulating material, by making the necessary holes and slots to expose the conductive material with which the first sheet of insulating material will be coupled;
- laminating a sheet of conductive material with the first sheet of insulating material so as to obtain a coupled assembly;
- etching of the conductive material to make conductive tracks according to a desired electrical scheme;
- drilling the laminate, to make through holes, intended for the assembly of electronic components;
- preparation of a second sheet of insulating material, making the necessary holes and slots to expose the conductive material;
- assembling the second sheet of insulating material on the sheet of conductive material so that the sheet of conductive material is sandwiched between the first and second sheet of insulating material.

The peculiarity of the invention is by the fact that the sheets of insulating material are flexible films of thin thickness and the sheet of conductive material is a flexible film of thin thickness, so as to obtain a flexible printed circuit board.

Furthermore, the conductive tracks of the sheet of conductive material are made by chemical etching of a design printed on the sheet of conductive material by silk-screen or by photographic masking of a photosensitive film coupled to the sheet of conductive material.

As an alternative to the prior drilling and slotting, it is possible to drill or cut one or both of the two insulating sheets by laser ablation, even after the coupling phase, so as to expose the conductor material, if it is necessary to expose only small areas of the conductor sheet for the welding of electronic components or areas destined to make external connections, or to make changes to the already coupled printed circuit board.

Further chemical or galvanic treatments are possible to achieve the desired surface protection degree of the conductive material and further finishing processes, according to the known techniques.

Further characteristics of the invention will become clearer from the detailed description that follows, referring to a purely exemplifying and therefore non-limiting embodiment thereof, illustrated in the attached drawings, in which:
Figs. 1, 2, 3 and 4 are sectional views, illustrating four steps for manufacturing a double-sided printed circuit board, according to the prior art;
Fig. 5 is a perspective view, illustrating a first sheet of insulating material, used to make a printed circuit board according to the invention;
Fig. 6 is a sectional view of the first sheet of insulating material of Fig. 5;
Fig. 7 is a sectional view illustrating the first sheet of insulating material of Fig. 6 coupled with a sheet of conductive material;
Fig. 8 is a perspective view of the coupled of Fig. 7 turned upside down, illustrating the etching of conductive tracks on the conductive sheet;
Fig. 9 is a perspective view illustrating the laminate of Fig. 8 and an exploded view of a second sheet of insulating material;
Fig. 10 is a sectional view, illustrating a printed circuit according to the invention obtained from the coupling illustrated in Fig. 9; and
Fig. 11 is a sectional view, illustrating a printed circuit similar to that of Fig. 10, in which some electronic components have been mounted.

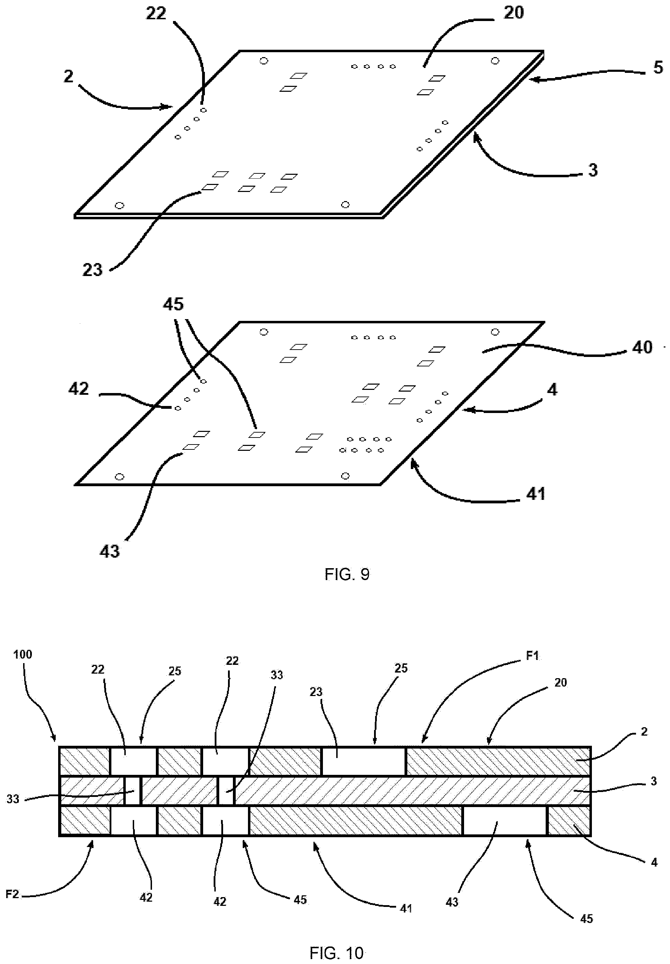

With the aid of Figs. from 5 to 10 the printed circuit board according to the invention is described, illustrated in Fig. 10 and indicated as a whole with the reference number 100.

Hereinafter, the terms lower and upper refer to the arrangement of the printed circuit board (100) illustrated in Figure 10. The printed circuit board (100) is double-sided and has an upper face (F1) and a lower face (F2). Electronic components or connections to external circuits must be mounted on each face (F1, F2) of the printed circuit board (100).

With reference to Figs. 5 and 6, the printed circuit board (100) is made starting from a first sheet (2) of insulating material. The first sheet (2) of insulating material has an upper face (20) intended to face outwards and a lower face (21) opposite the upper face (20).

The first sheet (2) of insulating material is a flexible sheet having a thin thickness between 12 and 250 µm. The first sheet (2) is a film of polymeric material such as for example Polymide (PI), Polyester (PL), Polyethylene Terephthalate (PET), Polyethylene Naphthalate (PEN), Polyvinyl Fluoride (PVDF), Polytetrafluoroethylene (PTFE).

Openings (25) are made in the first sheet (2) of insulating material in correspondence with areas which in the printed circuit board (100) will have to constitute uncovered areas for soldering electronic components or connections to external circuits on the upper face (F1) of the printed circuit (100). The openings (25) can comprise holes (22) and slots (23). The openings (25) can be made by machining, chemical etching or laser cutting. Advantageously, the openings (25) of the first insulating sheet can be made by chemical etching, so as to follow a pattern in accordance with the conductive tracks of the conductive sheet (3).

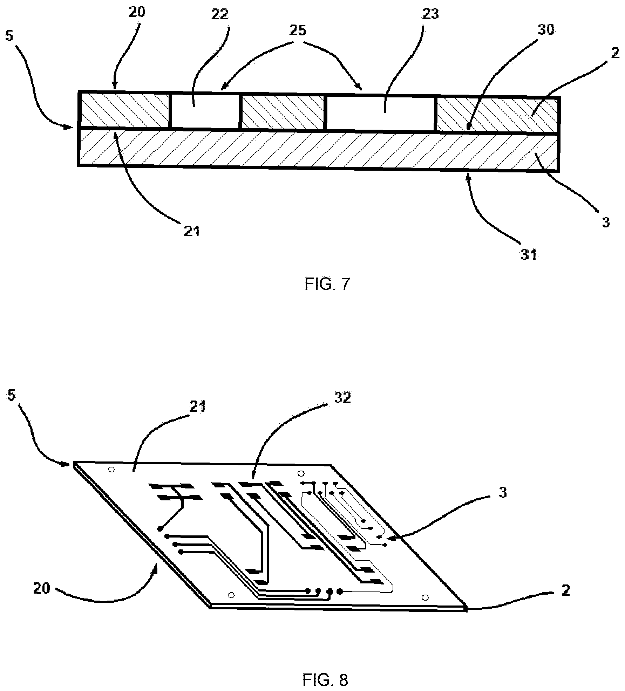

With reference to Fig. 7, the first sheet (2) of insulating material is coupled to a sheet (3) of conductive material so as to obtain a coupled assembly (5). The openings (25) of the first sheet of insulating material make the sheet (3) of conductive material accessible from the upper face (F1) of the printed circuit.

The sheet of conductive material (3) has an upper face (30) and a lower face (31). Then the lower face (21) of the first sheet (2) of insulating material is coupled to the upper face (30) of the sheet (3) of conductive material.

The conductive material sheet (3) is a flexible sheet having a thin thickness between 17 and 105 µm. The sheet of conductive material (3) can be a copper sheet.

After the coupling the sheet of conductive material (3) is etched to create conductive tracks (32). Fig. 8 illustrates the conductive tracks (32) on the lower face (21) of the first sheet of insulating material, obtained by engraving the sheet of conductive material (3). The conductive tracks can be obtained by means of processes, such as silk-screen or photographic masking, which allow the creation of complex designs and a mass industrialization process of the printed circuit to be obtained.

For example, a silk-screen printing of the design of the conductive tracks (32) can be made on the sheet of conductive material (3) followed by a chemical etching of the sheet of conductive material (3) by means of strong acids or alkalis.

As an alternative to silk-screen printing, a photosensitive protective film (photoresist) can be laminated onto the conductive sheet (3), with subsequent exposure of the photosensitive film to an image of the desired circuit layout, followed by development of the photosensitive film, and chemical etching of the sheet of conductive material (3) by means of strong acids or alkalis, leaving the conductive tracks (32).

With reference to Fig. 9, a second sheet (4) of insulating material is prepared to be coupled to the conductive sheet (3) of the coupled assembly (5).

The second sheet (4) of insulating material is a flexible sheet having a thin thickness between 12 and 250 µm. The second sheet (4) of insulating material is a film of polymeric material such as for example Polymide (PI), Polyester (PL), Polyethylene Terephthalate (PET), Polyethylene Naphthalate (PEN), Polyvinyl Fluoride (PVDF), Polytetrafluoroethylene (PTFE ).

The second sheet (4) of insulating material has a lower face (41) intended to face outwards and an upper face (40) opposite the lower face (41).

Openings (45) are made in the second sheet (4) of insulating material to allow access to the sheet (3) of conductive material in correspondence with areas which in the printed circuit board (100) will be intended for soldering of electronic components or connections to external circuits on the lower face (F2) of the printed circuit (100). The openings (45) of the second sheet (4) of insulating material can comprise holes (42) and slots (43). The openings (45) of the second sheet (4) of insulating material can be made by machining, chemical etching or laser cutting. Advantageously, the openings (45) of the second insulating sheet can be made by chemical etching, so as to follow a pattern in accordance with the conductive tracks of the conductive sheet (3).

With reference to Fig. 10, the upper face (40) of the second sheet (2) of insulating material is coupled to the lower face (31) of the sheet (3) of conductive material.

In this way, a flexible type printed circuit board (100) is obtained, having a thin thickness between 41 and 605 µm.

The sheet of conductive material (3) has through holes (33) arranged so as to put the openings (25) of the first sheet of insulating material in communication with respective openings (45) of the second sheet of insulating material. Through holes (33) may be required for mounting electronic or electrical components with pins or leads, such as connectors. The through holes (33) of the conductive sheet can be made by mechanical machining, or laser cutting on the laminate (5) or on the printed circuit board (100).

Fig. 10 illustrates an example in which some holes (22) of the first sheet of insulating material correspond to respective holes (42) of the second sheet of insulating material. In this case, in the sheet of conductive material (3), in addition to the tracks (32), the through holes (33) have been made in correspondence with the holes (22) of the first sheet of insulating material and the corresponding holes (42) of the second sheet of insulating material.

In some cases it may be advantageous to make the openings (25, 45) by laser ablation of the first sheet (2) or of the second sheet (4) of insulating material in a subsequent step of making the already coupled printed circuit board (100).

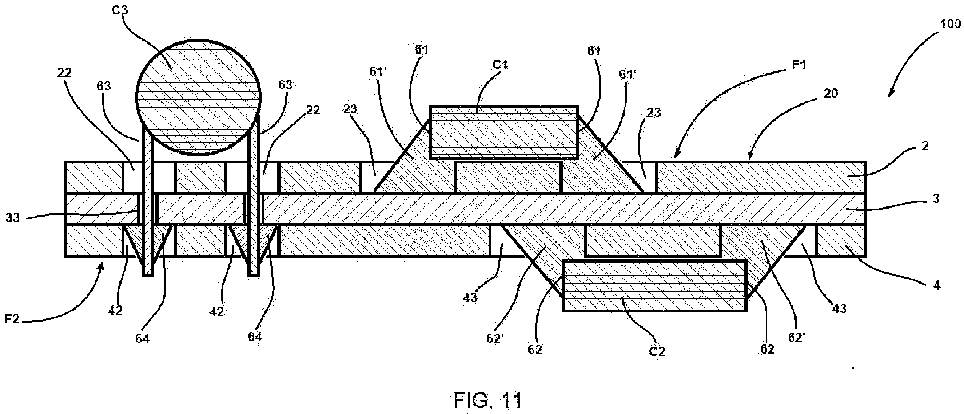

Fig. 11 illustrates the printed circuit board (100) which includes:
- a first electronic component (C1) mounted on the first face (F1) of the printed circuit board (100), having the connection terminals (61) positioned in correspondence with two slots (23) of the first sheet of insulating material, and connected to the sheet of conductive material (3) by soldering joints (61');
- a second electronic component (C2) mounted on the second face (F2) of the printed circuit (100), having the connection terminals (62) positioned in correspondence with two slots (43) of the second sheet of insulating material, and connected to the sheet of conductive material (3) by soldering joints (62');
- a third electronic component (C3) mounted on the first face (F1) of the printed circuit, having two conductive pins (63) inserted in two holes (22) of the first sheet of insulating material, and connected to the sheet of conductive material (3) by means of soldering joints (64) placed on the second face (F2) of the printed circuit (100), in correspondence with two holes (42) of the second sheet of insulating material.

The differences and advantages of the printed circuit board (100) according to the invention with respect to the printed circuit board (1) of the prior art are evident.

The printed circuit board (1) of the prior art has a sheet (10) of insulating material sandwiched between two sheets (11, 12) of conductive material. Furthermore, the sheet (10) of insulating material has holes (13) with metallization (14) to put the two sheets (11, 12) of conductive material in communication. As a result, such a printed circuit board implies a considerable waste of very expensive conductive metallic material.

The printed circuit board (100) according to the invention has a single sheet of conductive material (3) sandwiched between two sheets (2, 4) of insulating material. Furthermore, this printed circuit does not require any metallization in the openings (25, 45) of the insulating sheets. As a result, such a printed circuit implies a considerable saving of very expensive conductive metallic material.

To the present embodiment of the invention, equivalent variations and modifications can be made, within the reach of a person skilled in the art, which in any case fall within the scope of the invention expressed by the appended claims.

## Claims

1. Printed circuit board (100), of the double-sided type, comprising an upper face (F1) and a lower face (F2) intended to house electronic components or connections to external circuits;
said printed circuit board (100) comprising a single sheet of conductive material (3), etched with conductive tracks (32) and sandwiched between a first sheet (2) of insulating material and a second sheet (3) of insulating material;
said first sheet (2) of insulating material having openings (25) to allow access to said sheet (3) of conductive material in correspondence with areas which in the printed circuit board (100) must constitute uncovered areas intended for soldering of electronic components or connections to external circuits on the upper face (F1) of the printed circuit board (100); and
said second sheet (4) of insulating material having openings (45) to allow access to said sheet (3) of conductive material in correspondence with areas which in the printed circuit board (100) must constitute uncovered areas intended for soldering of electronic components or connections to external circuits on the lower face (F2) of the printed circuit (100);
**characterized in that**
said sheet of conductive material (3) is a thin flexible sheet and said first sheet (2) of insulating material and second sheet (4) of insulating material are both thin flexible sheets, so as to obtain a thin flexible printed circuit; and
said conductive tracks (32) of the sheet of conductive material are made by silk-screen or photographic masking, by chemical etching of a design printed on the sheet of conductive material or on a photosensitive film coupled to the sheet of conductive material.

2. Printed circuit board (100) according to claim 1, wherein
the sheet of conductive material (3) is a flexible sheet having a thin thickness between 17 and 105 µm;
the first sheet (2) of insulating material is a flexible sheet having a thin thickness of between 12 and 250 µm; and
the second sheet (4) of insulating material is a flexible sheet having a thin thickness between 12 and 250 µm.

3. Printed circuit board (100) according to claim 1 or 2, wherein said openings (25) of the first sheet of insulating material and said openings (45) of the second sheet of insulating material are obtained by chemical etching.

4. Printed circuit board (100) according to any one of the preceding claims, wherein said openings (25) of the first sheet of insulating material comprise holes (22) and slots (23) and said openings (45) of the second sheet of insulating material comprise holes (42) and slots (43).

5. Printed circuit board (100) according to any one of the preceding claims, wherein said sheet of conductive material (3) has through holes (33) arranged so as to put openings (25) of the first sheet of insulating material in communication with respective openings (45) of the second sheet of insulating material.

6. Printed circuit board (100) according to claim 5, comprising:
- a first electronic component (C1) mounted on the first face (F1) of the printed circuit board (100), having connection terminals (61) positioned in correspondence with two slots (23) of the first sheet of insulating material, and connected to the sheet of conductive material (3) by solder joints (61');
- a second electronic component (C2) mounted on the second face (F2) of the printed circuit (100), having connection terminals (62) positioned in correspondence with two slots (43) of the second sheet of insulating material, and connected to the sheet of conductive material (3) by solder joints (62');
- a third electronic component (C3) mounted on the first face (F1) of the printed circuit, having two conductive pins (63) inserted in two holes (22) of the first sheet of insulating material, and connected to the sheet of conductive material (3) by means of solder joints (64) placed on the second face (F2) of the printed circuit (100), in correspondence with two holes (42) of the second sheet of insulating material.

7. Manufacturing method of a printed circuit board (100) of the double-sided type, comprising an upper face (F1) and a lower face (F2) intended to house electronic components or connections to external circuits; said method including the following steps:
- engraving of a first sheet (2) of insulating material to make openings (25) in correspondence with areas which in the printed circuit board (100) will have uncovered areas intended for soldering electronic components or connections to external circuits on the upper face (F1) of the printed circuit board;
- coupling of a sheet (3) of conductive material on said sheet (2) of insulating material so as to obtain a coupled assembly (5);
- etching of said sheet (3) of conductive material to obtain tracks (32) on said coupled assembly (5);
- engraving of a second sheet (4) of insulating material to create openings (45) in areas which in the printed circuit board (100) will have uncovered areas intended for soldering electronic components or connections to external circuits on the lower face (F2) of the printed circuit; and
- coupling of the second sheet (4) of insulating material with the sheet of conductive material (3) of the coupled assembly (5) so as to obtain a single sheet of conductive material (3) with tracks (32) sandwiched between the first sheet (2) of insulating material and the second sheet (3) of insulating material,
**characterized in that**
said sheet of conductive material (3) is a thin flexible sheet and said first sheet (2) of insulating material and second sheet (4) of insulating material are both thin flexible sheets, so as to obtain a thin flexible printed circuit; and
said conductive tracks (32) of the sheet of conductive material are made by silk-screen or photographic masking, by chemical etching of a design printed on the sheet of conductive material or on a photosensitive film coupled to the sheet of conductive material.

8. Method according to claim 7, wherein the sheet of conductive material (3) is a flexible sheet having a thin thickness between 17 and 105 µm;
the first sheet (2) of insulating material is a flexible sheet having a thin thickness between 12 and 250 µm; and
the second sheet (4) of insulating material is a flexible sheet having a thin thickness between 12 and 250 µm.

9. Method according to claim 7 or 8, wherein said openings (25) of the first sheet of insulating material and said openings (45) of the second sheet of insulating material are obtained by chemical etching.

10. Method according to any one of claims from 7 to 9, wherein through holes (33) are made in said sheet of conductive material (3) arranged so as to put openings (25) of the first sheet of insulating material in communication with respective openings (45) of the second sheet of insulating material.

11. Method according to claim 10, comprising the following steps:
- assembly of a first electronic component (C1) on the first face (F1) of the printed circuit board (100), with connection terminals (61) positioned in correspondence with two slots (23) of the first sheet of insulating material, and connected to the sheet of conductive material (3) by soldering joints (61');
- assembly of a second electronic component (C2) on the second face (F2) of the printed circuit board (100), with connection terminals (62) positioned in correspondence with two slots (43) of the second sheet of insulating material, and connected to the sheet of conductive material (3) by soldering joints (62');
- assembly of a third electronic component (C3) on the first face (F1) of the printed circuit board (100), having two conductive pins (63) inserted in two holes (22) of the first sheet of insulating material, and connected to the sheet of conductive material (3) by means of soldering joints (64) placed on the second face (F2) of the printed circuit board (100), in correspondence with two holes (42) of the second sheet of insulating material.
